# EUROPEAN PATENT APPLICATION

(11) **EP 2 592 614 A1**
(43) Date of publication of application: **15.05.2013**
(21) Application number: 12184816.2
(22) Date of filing: 18.09.2012
(51) Int. Cl.: G09G 3/00, G09G 3/20, G06F 1/16, H04N 5/64

(54) **Flexible display apparatus**

(30) Priority: 08.11.2011 KR 20110116039
(71) Applicant: Samsung Electronics Co., Ltd., Suwon-si, Gyeonggi-do, 443-742 (KR)
(72) Inventor: Joo, Seung-sook, Seoul (KR); Song, Sung-ho, Gyeonggi-do (KR)
(74) Representative: Taor, Simon Edward William

(57) **Abstract**

A flexible display apparatus (1) includes a flexible display panel (10); a panel deformation member (20) that is disposed on a rear surface of the flexible display panel and deforms the flexible display panel; a panel rotation unit (30) that supports and rotates the flexible display panel; a control unit (40) that controls the panel rotation unit to adjust a position of the flexible display panel and controls the panel deformation member to deform the flexible display panel; and a command input device (50) that is formed separately from the flexible display panel and inputs a rotation position command and a curvature change command for the flexible display panel to the control unit.

## Description

Exemplary embodiments relate to a flat display apparatus. More particularly, the exemplary embodiments relate to a flexible display apparatus a portion of which can be bent at a predetermined curvature for expanding field of view.

Generally, a field of view of a flat display apparatus such as a liquid crystal display (LCD) or a plasma display panel (PDP) has a certain range. Therefore, a user cannot see images, etc. displayed on a screen of the flat display apparatus from a location beyond the range of the field of view. To address this problem, a rotating apparatus that can rotate the flat display apparatus by a predetermined angle corresponding to a location of the user has been provided as a peripheral device of the flat display apparatus. For example, the rotating apparatus may include an electric stand that is used to rotate the flat display apparatus installed on a stand and an electric wall that is used to rotate the flat display apparatus installed on a wall mount.

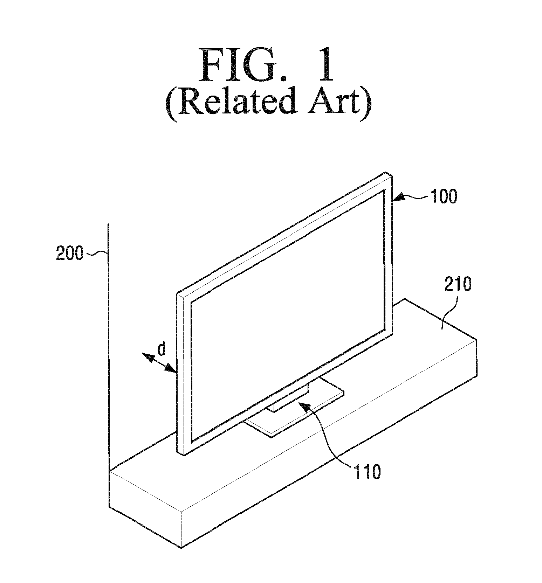

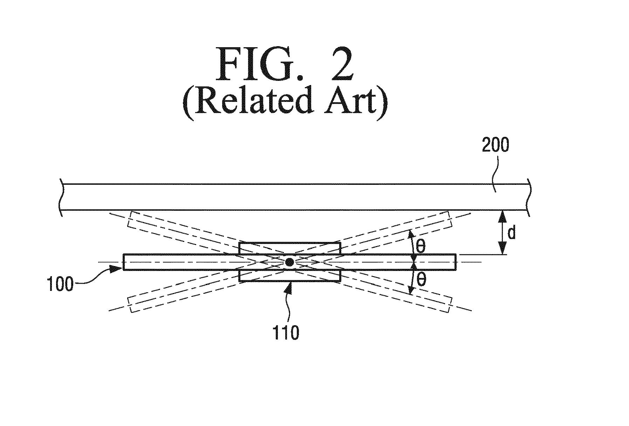

However, as illustrated in Figs. 1 and 2, when the flat display apparatus 100 is installed adjacent to a wall 200, the rotating apparatus 110 has a problem that a rotating angle θ by which the rotating apparatus 110 can rotate the flat display apparatus 100 is limited by a distance d between the wall 200 and the flat display apparatus 100. In other words, as illustrated in FIG. 2, a rotation range of the flat display apparatus 100 is limited to an angle of -θ ∼ +θ. Base 210 is a base on which the flat display apparatus 100 is installed.

However, increasing the distance d between the flat display apparatus 100 and the wall 200 in order to expand the rotation range of the flat display apparatus 100 takes up a lot of space when installing the flat display apparatus 100 and it is inefficient.

Therefore, a flexible display apparatus that can bend a portion of a screen toward a user who is beyond a field of view is needed so that the user can see images displayed on the screen of the flexible display apparatus even when the user is beyond the rotation range of the conventional rotating apparatus,.

The exemplary embodiments have been developed order to address the above drawbacks and other problems associated with the conventional arrangement. An aspect of the exemplary embodiments relates to a flexible display apparatus that can expand the field of view of a screen so that a user can watch images displayed on the screen from a location beyond the range of the field of view of the screen.

The above aspects and/or other features of the exemplary embodiments may be achieved by providing a flexible display apparatus, which may include a flexible display panel provided with a screen on which information is displayed on a front surface thereof; a panel deformation member that is disposed on a rear surface of the flexible display panel and deforms the flexible display panel; a panel rotation unit that supports and rotates the flexible display panel; a panel position and deformation control unit that controls the panel rotation unit to adjust a position of the flexible display panel and controls the panel deformation member to deform the flexible display panel; and a command input device that is detached from the flexible display panel and inputs a rotation position command and a curvature change command of the flexible display panel to the panel position and deformation control unit.

The panel deformation member may include a thermal expansion member disposed on the rear surface of the flexible display panel; a heating unit which heats the thermal expansion member; and a cooling unit which cools the thermal expansion member.

The thermal expansion member may be disposed in a horizontal direction of the flexible display panel.

The thermal expansion member may be disposed in a vertical direction of the flexible display panel.

The thermal expansion member may include a current amplification device, a heater, or an electric bulb.

The cooling unit may include a fan, radiator, pipe,or coolant.

The thermal expansion member may be coated on or attached in a film shape onto the rear surface of the flexible display panel.

The thermal expansion member may include a bimetal.

The panel deformation member may include an air pressure device which deforms the flexible display panel.

The panel deformation member may include an electromagnetic force device including an electromagnet which deforms the flexible display panel.

The panel rotation unit may include an electric stand or an electric wall.

According to another aspect of an exemplary embodiment, a flexible display apparatus includes a flexible display panel; a panel bending member disposed on the flexible display panel which bends the flexible display panel; and a control unit comprising a processor which controls the panel bending member to bend the flexible display panel.

According to an aspect of the invention, there is provided a flexible display apparatus as set out in claim 1. Preferred features of this aspect are set out in claims 2 to 11.

Other objects, advantages and salient features of the exemplary embodiments will become apparent from the following detailed description, which, taken in conjunction with the annexed drawings, illustrates the exemplary embodiments.

These and/or other aspects and advantages of the exemplary embodiments will become apparent and more readily appreciated from the following description of the embodiments, taken in conjunction with the accompanying drawings of which:
FIG. 1 is a perspective view illustrating a conventional flat display apparatus;
FIG. 2 is a view illustrating a limited range of motion corresponding to a limiting angle of the flat display apparatus of FIG. 1 when a display panel of the flat display apparatus is rotated by a rotating apparatus;
FIG. 3 is a rear view illustrating a flexible display apparatus according to an aspect of the exemplary embodiments;
FIG. 4 is a view explaining a state that a flexible display panel is deformed by a panel deformation member of a flexible display apparatus according to an aspect of an exemplary embodiments;
FIG. 5 is a rear view illustrating a flexible display apparatus according to another aspect of an exemplary embodiment;
FIG. 6 is a rear view illustrating a flexible display apparatus according to another aspect of an exemplary embodiment;
FIG. 7 is a rear view illustrating a flexible display apparatus according to another aspect of an exemplary embodiment;
FIG. 8 is a plan view illustrating when a user is beyond field of view of a flexible display apparatus according to an aspect of an exemplary embodiment
FIG. 9A is a perspective view illustrating a flexible display apparatus according to an aspect of an exemplary embodiment when a flexible display panel thereof is rotated at the maximum angle by a panel rotation unit thereof;
FIG. 9B is a plan view illustrating a location relationship between a user and the flexible display apparatus that is in a state of FIG. 9A;
FIG. 10A is a perspective view illustrating a flexible display apparatus according to an aspect of an exemplary embodiment when a flexible display panel thereof is bent from a state of FIG. 9A toward a user by a panel deformation member thereof; and
FIG. 10B is a plan view illustrating a location relationship between a user and the flexible display apparatus that is in a state of FIG. 10A.

Throughout the drawings, like reference numerals will be understood to refer to like parts, components and structures.

Hereinafter, certain exemplary embodiments will be described in detail with reference to the accompanying drawings.

The matters described herein, such as a detailed construction and elements thereof, are provided to assist in a comprehensive understanding of this description. Thus, it is apparent that exemplary embodiments may be carried out without those defined matters. Also, well-known functions or constructions are omitted to provide a clear and concise description of exemplary embodiments. Further, dimensions of various elements in the accompanying drawings may be arbitrarily increased or decreased for assisting in a comprehensive understanding.

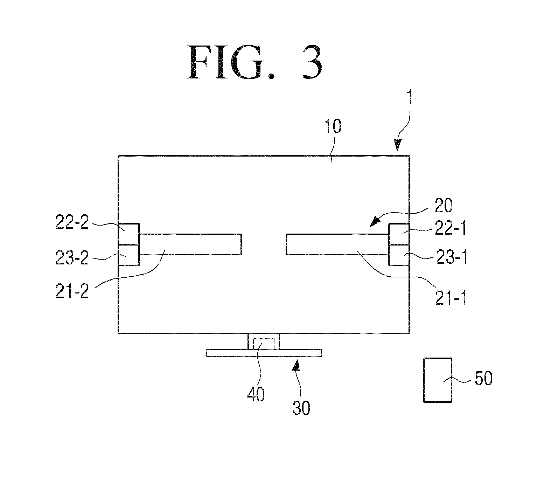

FIG. 3 is a rear view illustrating a rear surface of a flexible display apparatus according to an aspect of an exemplary embodiment.

Referring to FIG. 3, a flexible display apparatus 1 according to an aspect of an exemplary embodiment includes a flexible display panel 10, a panel deformation member 20, a panel rotation unit 30, a panel position and deformation control unit 40, and a command input device 50.

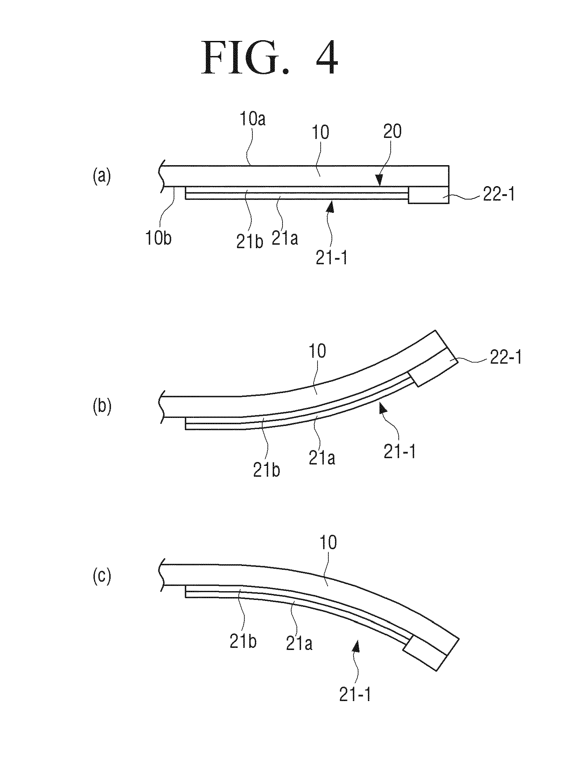

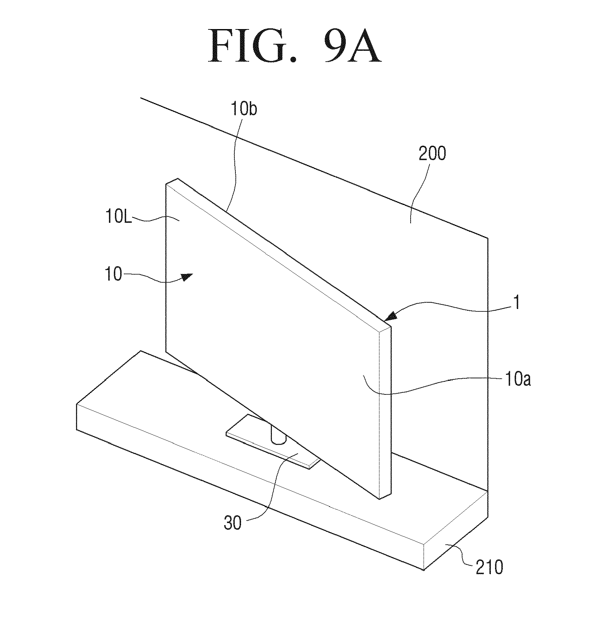

The flexible display panel 10 is a type of the flat display apparatus and has a screen on which information such as text, images, moving images, etc. is output on a front surface 10a (see FIGS. 4 and 9A) of the flexible display panel 10. If a force is applied from the outside, the flexible display panel 10 has a property of being bent depending on the size and direction of the force applied from the outside.

The flexible display panel 10 that is used for the flexible display apparatus 1 according to an aspect of an exemplary embodiment may be formed in a rectangular shape as the same as a general flat display apparatus, for example, a flat-panel television. Also, the flexible display panel 10 that is used for the flexible display apparatus 1 according to an aspect of an exemplary embodiment may use various types of display panels as long as they can be bent or restored to their original state if an external force is applied.

The panel deformation member 20 is disposed on the rear surface 10b of the flexible display panel 10 and is formed to apply a force to the flexible display panel 10 in order to change a curvature of the flexible display panel 10, that is, to bend the flexible display panel 10.

Anything can be used as the panel deformation member 20 as long as it can apply force to the flexible display panel 10. Further, the panel deformation member 20 may have a property of being deformed along with deformation of the flexible display panel 10.

The flexible display apparatus 1 according to an aspect of an exemplary embodiment as illustrated in FIG. 3 uses thermal expansion members 21-1 and 21-2 that can apply force to the flexible display panel 10 depending on a change in temperature of the panel deformation member 20. The thermal expansion members 21-1 and 21-2 are disposed on the rear surface 10b of the flexible display panel 10 and have a length which corresponds to the degree of bending that is required of the flexible display panel 10.

Also, the thermal expansion members 21-1 and 21-2 may be formed by coating the rear surface 10b of the flexible display panel 10 or by bonding thin films having a band shape onto the rear surface 10b of the flexible display panel 10.

A bimetal may be used as an example of the thermal expansion members 21-1 and 21-2. The bimetal is formed by laying two metals each having a different coefficient of thermal expansion one on top of the other. If a temperature is increased by heat, the bimetal is bent toward the metal having a small coefficient of thermal expansion. If temperature is lowered, the bimetal is restored to its original state. Metals having a small coefficient of thermal expansion, that is, metals that are difficult to expand may include nickel and iron alloys. Metals having a large coefficient of thermal expansion, that is, metals that are more easily expanded may include alloys of nickel, manganese and iron; alloys of nickel, manganese and copper; or alloys of nickel, molybdenum and iron.

FIG. 4 illustrates a portion of the flexible display apparatus 1 using a bimetal as the thermal expansion members 21-1 and 21-2 when the flexible display panel 10 thereof is bent by the bimetal that is deformed according to a change in temperature.

FIG. 4(a) illustrates a state of the flexible display panel 10 when the thermal expansion member 21-1, that is, the bimetal is in a room-temperature, namely, when the bimetal is not heated or cooled. In this case, the flexible display panel 10 maintains a flat state. In this state, if the bimetal 21-1 is heated, the bimetal 21-1 is bent toward the metal 21b having the small coefficient of thermal expansion. As a result, as illustrated in FIG. 4(b), the flexible display panel 10 on which the bimetal 21-1 is attached receives force, thereby being concavely bent toward the front side thereof (upside in FIG. 4).

If in this state, the temperature is lowered so the bimetal 21-1 is cooled, the metal 21a having the large coefficient of thermal expansion of the bimetal 21-1 is restored to its original state so that the bimetal 21-1 is restored to its original state as illustrated in FIG. 4(a). As a result, the flexible display panel 10 on which the bimetal 21-1 is attached is restored to its flat original state.

If the bimetal 21-1 is cooled so the temperature is lowered below the room-temperature, the bimetal 21-1 is bent toward the metal 21a having the large coefficient of thermal expansion. As a result, as illustrated in FIG. 4(c), the flexible display panel 10 on which the bimetal 21-1 is attached receives force, thereby being concavely bent toward the rear side thereof (downside in FIG. 4). If in this state, the temperature is increased so the bimetal 21-1 is heated, the metal 21a having the large coefficient of thermal expansion of the bimetal 21-1 is restored to its original state so that the bimetal 21-1 is restored to its original state as illustrated in FIG. 4(a). As a result, the flexible display panel 10 on which the bimetal 21-1 is attached is restored to its flat original state.

Alternatively, although not illustrated, a material having a coefficient of thermal expansion larger than that of the flexible display panel 10 may be used as the thermal expansion members and may be attached on the rear surface 10b of the flexible display panel 10. In this case, if a heating unit heats the thermal expansion members, the length of thermal expansion member is increased corresponding to the increased temperature but the length of the flexible display panel 10 on which the thermal expansion members are attached is not increased so that the flexible display panel 10 is bent toward the front surface 10a thereof.

The heating units 22-1 and 22-2 are devices to heat the thermal expansion members 21-1 and 21-2. A current amplification device, a heater, an electric bulb, and the like may be used as the heating units 22-1 and 22-2.

In an aspect of an exemplary embodiment illustrated in FIG. 3, each of the thermal expansion members 21-1 and 21-2 is disposed by one on the left and right sides of the flexible display panel 10, and two heating units 22-1 and 22-2 are disposed to correspond to the left and right thermal expansion members 21-1 and 21-2, respectively. The bimetals are used as the thermal expansion members 21-1 and 21-2, and the current amplification devices are used as the heating units 22-1 and 22-2. The current amplification device may be configured of electric circuits that can generate heat to heat the thermal expansion members 21-1 and 21-2 if a predetermined current is applied to.

Accordingly, if the left heating unit 22-2 operates, the left thermal expansion member 21-2 is heated so that a left portion of the flexible display panel 10 is bent toward the front side thereof (a side of the paper on which FIG. 3 is illustrated). At this time, degree of bending of the flexible display panel 10 may be determined by controlling the temperature of the heating units 22-1 and 22-2. If the right heating unit 22-1 operates, the right thermal expansion member 21-1 is heated so that the right portion of the flexible display panel 10 is bent.

After that, if the heating units 22-1 and 22-2 are not being operated, the heating units 22-1 and 22-2 are cooled and restored to its original state so that the flexible display panel 10 is also restored to its flat original state. At this time, if the thermal expansion members 21-1 and 21-2 are cooled in a natural state, it takes a long time for the thermal expansion members 21-1 and 21-2 to be restored to its original state. Accordingly, for rapid cooling of the thermal expansion members 21-1 and 21-2, cooling units 23-1 and 23-2 may be disposed on the flexible display panel 10. The cooling units 23-1 and 23-2 may use various devices such as fans, pipes, and radiators as long as they can cool the heating units 22-1 and 22-2.

In an aspect of the exemplary embodiments illustrated in FIG. 3, cooling fans are used as the cooling units 23-1 and 23-2, and the cooling fans are disposed next to the heating units 22-1 and 22-2 on the left and right end portions of the flexible display panel 10. Accordingly, when restoring the bent flexible display panel 10 to its original state, the cooling units 23-1 and 23-2 are operated to cool the heating units 22-1 and 22-2. As a result, the heating units 22-1 and 22-2 are rapidly cooled so that the flexible display panel 10 also is rapidly restored to its original state.

In the above description, the cooling fan is used as the cooling units 23-1 and 23-2; however, this does not limit the type of the cooling units 23-1 and 23-2. Alternatively, a coolant circulating system may be used as the cooling units 23-1 and 23-2. For example, a cooling structure including a cooling pipe that is disposed adjacent to the thermal expansion members 21-1 and 21-2 and coolant that is circulated in the cooling pipe may be used as the cooling units 23-1 and 23-2. The cooling pipe may be formed of a material that can be deformed along with the flexible display panel 10.

In the above explanation, the panel deformation member 20 is disposed in a direction parallel to the ground, that is, in the lengthwise direction of the flexible display panel 10; however, this is only one example, According to a method of attaching the panel deformation member 20, the flexible display panel 10 may be deformed in other directions.

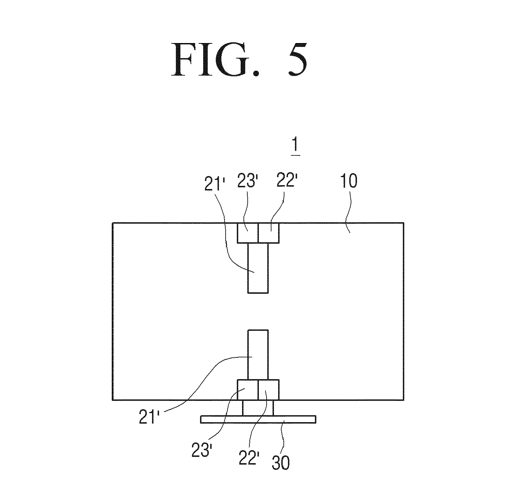

For example, as illustrated in FIG. 5, two thermal expansion members 21' consisting of the panel deformation member 20 may be disposed in a direction perpendicular to the ground, that is, in a height direction of the flexible display panel 10. At this time, two heating units 22' and two cooling units 23' also are arranged in the height direction of the flexible display panel 10. In the flexible display panel 10 as illustrated in FIG. 3, the left and right portions of the flexible display panel 10 are deformed. However, in the flexible display panel 10 as illustrated in FIG. 5, the upper and lower portions of the flexible display panel 10 are bent toward the front side thereof.

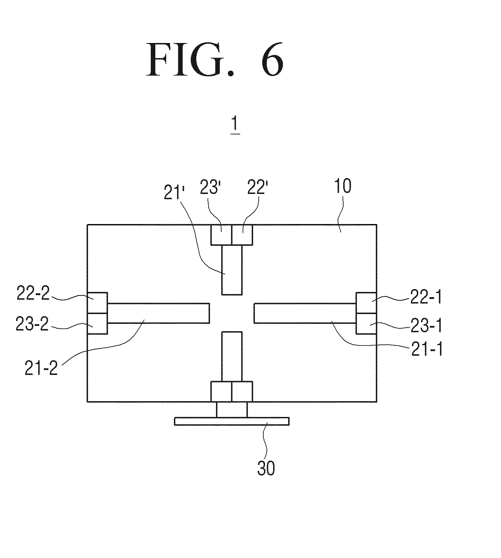

Also, as illustrated in FIG. 6, four thermal expansion members 21-1, 21-2 and 21' consisting of the panel deformation member 20 may be disposed on the rear surface 10b of the flexible display panel 10 in a substantially crisscross shape in directions parallel and perpendicular to the ground. Four heating units 22-1, 22-2 and 22' and four cooling units 23-1, 23-2 and 23' also are arranged in the lengthwise and height directions of the flexible display panel 10. In this case, all the left and right portions and the upper and lower portions of the flexible display panel 10 may be deformed.

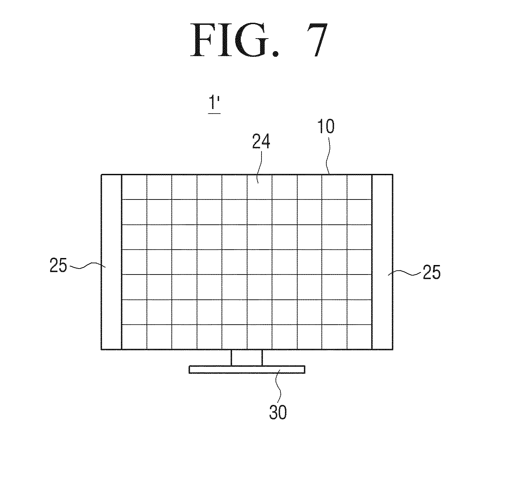

In another example illustrated in FIG. 7, the panel deformation member 24 may be disposed on the entire rear surface 10b of the flexible display panel 10 of the flexible display apparatus 1'. The panel deformation member 24 may be formed in a plurality of lattices and disposed on the rear surface 10b of the flexible display panel 10. In this case, a plurality of heating units also are disposed according to a one to one correspondence with the plurality of panel deformation members 24. The plurality of heating units are used to control temperature of each of the plurality of panel deformation members 24 so that the shape of the flexible display panel 10 can be arbitrarily deformed. Further, for rapidly restoring the deformed flexible display panel 10 to its original state, cooling units 25 may be disposed on the left and right end portions of the flexible display panel 10.

In the above description, the thermal expansion members the lengths of which are changed by heat are used as the panel deformation member 20; however, this does not limit the panel deformation member 20. For example, electromagnetic force of electromagnets may be used to deform the flexible display panel 10 or air bags that can be expanded or contracted by air pressure may be used to deform the flexible display panel 10.

The panel rotation unit 30 supports the flexible display panel 10 and is formed to rotate the flexible display panel 10 within a predetermined range of angles. An electric stand comprising an electric motor which rotates a rotating member of the electric stand coupled to the flexible display panel or an electric wall comprising an electric motor which rotates a wall member coupled to the flexible display panel may be used as the panel rotation unit 30. According to an aspect of an exemplary embodiment, the electric stand is used as the panel rotation unit 30. The panel rotation unit 30, i.e. a rotating base, may be formed to have the same structure as that of the conventional rotating apparatus 110 that is used to rotate the flat display apparatus 100. Therefore, a detailed explanation of the panel rotation unit 30 will be omitted.

The panel position and deformation control unit 40 may comprise a controller or a processor and receives commands transmitted from the command input device 50 and controls the panel rotation unit 30 and the panel deformation member 20 so as to change the position and curvature of the flexible display panel 10. The panel position and deformation control unit 40 controls the panel rotation unit 30 to cause the flexible display panel 10 to be rotated based on a center axis C of the panel rotation unit 30. The panel position and deformation control unit 40 may be set to rotate the flexible display panel 10 within the range of the maximum rotation angle that is determined by the distance d between the flexible display panel 10 and the wall 200. The panel position and deformation control unit 40 may be disposed inside the flexible display panel 10 or in the panel rotation unit 30.

The command input device 50 is formed separately from the flexible display panel 10 and inputs commands of the rotation position and curvature change of the flexible display panel 10 to the panel position and deformation control unit 40. A remote control may be used as the command input device 50. The command input device 50 can transmit a rotating angle, a portion that is going to be bent, a bending direction, and a bending degree of the flexible display panel 10 to the panel position and deformation control unit 40 using, for example, an infrared communication or a Bluetooth communication. Accordingly, the command input device 50 is provided with menus, command keys or buttons, etc., for selecting a rotating angle, a portion that is going to be bent, a bending direction, and a bending degree of the flexible display panel 10.

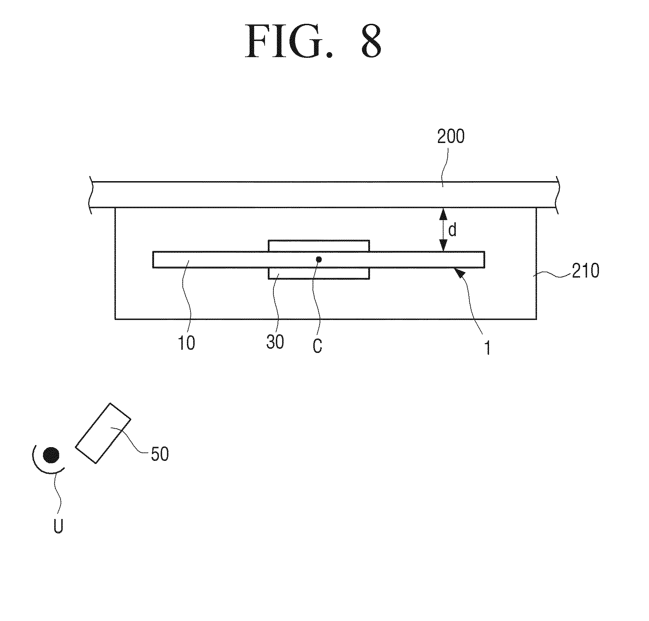

Hereinafter, operation of a flexible display apparatus according to an aspect of an exemplary embodiment having the above-described structure will be explained in detail with reference to FIGS. 8 to 10B.

Firstly, as illustrated in FIG. 8, a user U who is at a location beyond the field of view of the flexible display apparatus 1 on the base uses the command input device 50 to rotate the flexible display panel 10 by a desired angle. At this time, if a panel rotating button of the command input device 50 is pressed, a rotation signal is transmitted to the panel position and deformation control unit 40. Then, depending on the rotation signal, the panel position and deformation control unit 40 operates the panel rotation unit 30 to cause the flexible display panel 10 to be rotated around the center axis C.

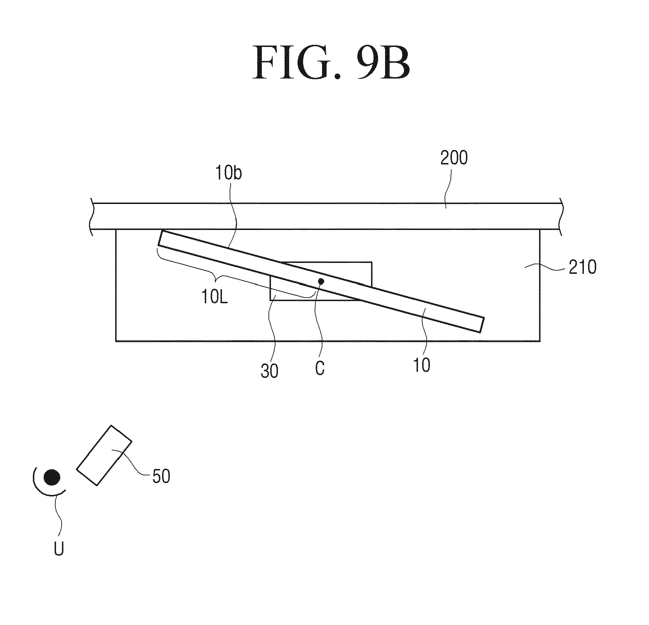

As illustrated in FIGS. 9A and 9B, if the rear surface 10b of the left portion 10L of the flexible display panel 10 comes close to the wall 200 and does not rotate any more, the user U presses a panel deformation button of the command input device 50. If the panel deformation button is pressed, a deformation signal is sent to the panel position and deformation control unit 40. Then, the panel position and deformation control unit 40 operates the panel deformation member 20 disposed on the rear surface 10b of the flexible display panel 10 to cause the flexible display panel 10 to be deformed in the direction that the user U desires.

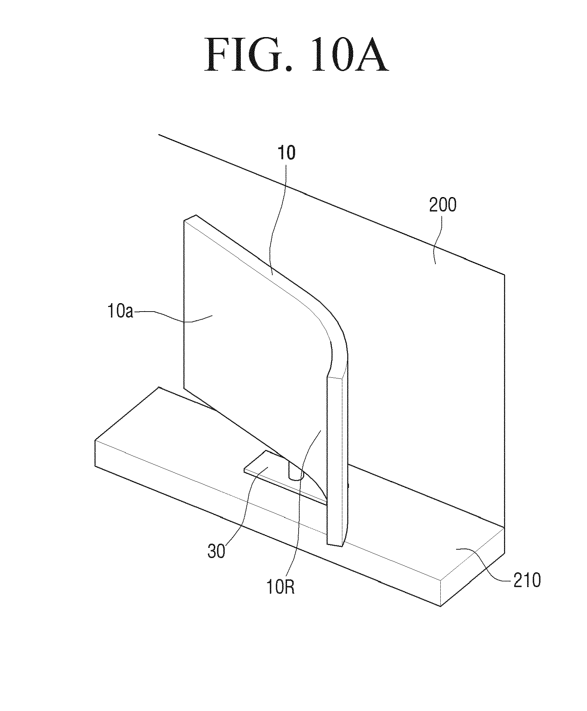

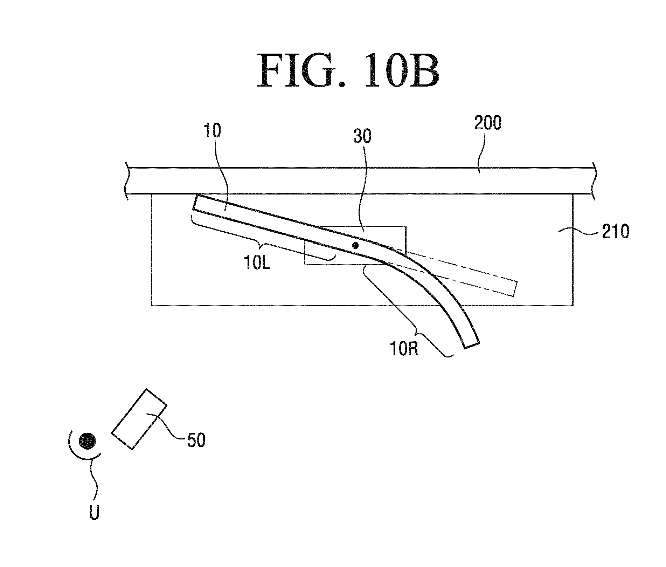

For example, as illustrated in FIG. 8, if the user U is on the left side of the flexible display apparatus 1, the user U sends the deformation signal so that the right portion 10R of the flexible display panel 10 is bent towards user's own. Then, as illustrated in FIGS. 10A and 10B, the right portion 10R of the flexible display panel 10 is bent to the user U. As a result, the user U can well see images being output on the screen of the flexible display apparatus 1. At this time, a control unit (not illustrated) of the flexible display apparatus 1 to control images being output on the screen of the flexible display apparatus 1 can adjust the images so that the images being output on the screen are not distorted by the bending of the flexible display panel 10.

While exemplary embodiments have been described, additional variations and modifications of the exemplary embodiments may occur to those skilled in the art once they learn of the basic inventive concepts. Therefore, the appended claims shall be construed to include both the above exemplary embodiments and all such variations and modifications that fall within the scope of the inventive concepts.

## Claims

1. A flexible display apparatus comprising:
a flexible display panel;
a panel deformation member that is disposed on a rear surface of the flexible display panel and arranged to deform the flexible display panel;
a panel rotation unit arranged to support and rotate the flexible display panel;
a panel position and deformation control unit arranged to control the panel rotation unit to adjust a position of the flexible display panel and to control the panel deformation member to deform the flexible display panel; and
a command input device that is detached from the flexible display panel and arranged to input a rotation position command and a curvature change command of the flexible display panel to the panel position and deformation control unit.

2. The flexible display apparatus of claim 1, wherein the panel deformation member comprises;
a thermal expansion member disposed on the rear surface of the flexible display panel;
a heating unit arranged to heat the thermal expansion member; and
a cooling unit arranged to cool the thermal expansion member.

3. The flexible display apparatus of claim 2, wherein the thermal expansion member is disposed in a horizontal direction of the flexible display panel.

4. The flexible display apparatus of claim 2 or 3, wherein the thermal expansion member is disposed in a vertical direction of the flexible display panel.

5. The flexible display apparatus of any one of claims 2 to 4, wherein the thermal expansion member comprises a current amplification device, a heater, or an electric bulb.

6. The flexible display apparatus of any one of claims 2 to 5, wherein the cooling unit comprises a fan, radiator, pipe, or coolant.

7. The flexible display apparatus of any one of claims 2 to 6, wherein the thermal expansion member is coated on or attached in a film shape onto the rear surface of the flexible display panel.

8. The flexible display apparatus of any one of claims 2 to 7, wherein the thermal expansion member comprises a bimetal.

9. The flexible display apparatus of any one of claims 1 to 8, wherein the panel deformation member comprises an air pressure device arranged to deform the flexible display panel.

10. The flexible display apparatus of any one of claims 1 to 9, wherein the panel deformation member comprises an electromagnetic force device comprising an electromagnet arranged to deform the flexible display panel.

11. The flexible display apparatus of any one of claims 1 to 10, wherein the panel rotation unit comprises an electric stand or an electric wall.
